Europäisches Patentamt

European Patent Office

Office européen des brevets

(19)

(11) Publication number : **0 496 614 A1**

(12) **EUROPEAN PATENT APPLICATION**

(21) Application number : **92300574.8**

(22) Date of filing : **23.01.92**

(51) Int. Cl.⁵ : **H01L 21/3105, H01L 21/60, H01L 21/90**

(30) Priority : **23.01.91 JP 6146/91**

(43) Date of publication of application :
**29.07.92 Bulletin 92/31**

(84) Designated Contracting States :
**DE FR GB**

(71) Applicant : **NEC CORPORATION**
**7-1, Shiba 5-chome Minato-ku**
**Tokyo 108-01 (JP)**

(72) Inventor : **Nakano, Eiichi, c/o NEC Corporation**
**7-1, Shiba 5-chome, Minato-ku**
**Tokyo (JP)**

(74) Representative : **Moir, Michael Christopher et al**
**MATHYS & SQUIRE, 10 Fleet Street**
**London EC4Y 1AY (GB)**

(54) Method for forming contact hole in process of manufacturing semiconductor device.

(57) A first interlayer insulator film (4) is formed on a principal surface of a substrate on which a step pattern is formed, so as to cover and preserve the step pattern (4B) formed on the substrate. A second interlayer insulator film (5) is deposited on a whole upper surface of the first interlayer insulator film (4) so as to planarize the step pattern (4B) preserved on the first interlayer insulator film (4). A photoresist pattern (6) having an opening at a position corresponding to a selected one of concaves in the step pattern (4B) preserved on the first interlayer insulator film (4) is formed on on the second interlayer insulator film (5). The second interlayer insulator film (5) exposed in the opening of the photoresist pattern (6) is anisotropically etched by means of an etching having a high selective etching ratio to the first interlayer insulator film (4). Then, the first interlayer insulator film (4) exposed in an opening formed in the second interlayer insulator film (5) is etched, so that a contact hole is formed in a self-alignment manner to extend through the first and second interlayer insulator films so as to reach the principle surface of the substrate. On the other hand, after removal of the photoresist (6), a planarized upper surface (5A) remains other than the contact hole.

FIGURE 1A

```
4A          5A  4A
      6A
                              6  PHOTORESIST
                              5  BPSG FILM
                              4  OXIDE FILM
                              3  OXIDE FILM
                              2  POLY-SI
                              9  OXIDE FILM
      4B          4B          1  SI SUBSTRATE
```

EP 0 496 614 A1

# FIGURE 1C

7 CONTACT HOLE

6 PHOTORESIST
5 BPSG FILM
4 OXIDE FILM
3 OXIDE FILM
2 POLY-SI
9 OXIDE FILM
1 Si SUBSTRATE

8    8

## Background of the invention

### Field of the invention

The present invention relates to a method for manufacturing a semiconductor device, and more specifically to a method for forming a contact hole in a self-alignment manner.

### Description of related art

In a conventional process for manufacturing a semiconductor device, for example, on a silicon substrate there are formed a number of devices such as MOSFETs, each of which includes, as a gate electrode, for example, a polysilicon deposited through a thin oxide film on the silicon substrate and an oxide film formed on the polysilicon. Therefore, the stacked layers of the polysilicon and the oxide film of each device forms a convex on the substrate. In other words, the substrate not covered with the stacked layers forms a concave pattern. Accordingly, the substrate has many steps on its surface. It one typical conventional method for forming a contact hole to the substrate in a self-alignment manner, an interlayer insulator film is deposited to cover the substrate so as to preserve the step pattern, and then, on the interlayer insulator film there is formed a photoresist film having an opening which has a size including therein a selected concave of the interlayer insulator film.

By using the photoresist as mask, an etching such as a reactive ion etching is performed, so that a portion of the interlayer insulator film exposing within the opening of the photoresist is anisotropically etched. Thus, a contact hole is formed in a self alignment manner to extend through the interlayer insulator film and to reach the substrate between a pair of adjacent stacked layers. Due to the anisotropic etching, the interlayer insulator film remains on a side wall of the stacked layers of the polysilicon and the oxide film to isolate a metallization layer to be formed in the contact hole from the stacked layers.

As seen from the above, in order to form the contact hole in the self alignment manner, an area in which an opening should be formed as a contact hole is required to necessarily have a concave portion defined by the step. However, many concaves ordinarily exist also in an area where the contact hole is not formed, as will be understood from the above description.

As a result, the steps in area where no contact hole is formed are preserved even after formation of metal wiring or metallization. This preserved steps become a cause which generates a break or open-circuit of an upper layer metallization due to a convex portion of the steps, and which short-circuits between adjacent wiring conductors due to a residue of the wiring metallization in a concave portion of the steps.

## Summary of the Invention

Accordingly, it is an object of the present invention to provide a method for forming a contact hole in a self-alignment manner, which has overcome the above mentioned defect of the conventional one.

Another object of the present invention is to provide a method for forming a contact hole in a self-alignment manner, with less risk of a break of an upper layer metallization and with less risk of a short-circuit between adjacent wiring conductors.

The above and other objects of the present invention are achieved in accordance with the present invention by a method for manufacturing a semiconductor device, comprising the steps of depositing a first interlayer insulator film on a principal surface of a substrate on which a step pattern having a plurality of concave and convex regions is formed, so as to cover the plurality of concave and convex regions and to preserve said step pattern, depositing a second interlayer insulator film on a whole upper surface of said first interlayer insulator film so as to form a substantially planar surface over said step pattern, forming on said second interlayer insulator film a photoresist pattern having an opening at a position corresponding to a selected said concave region in said step pattern, etching said second interlayer insulator film exposed in said opening of said photoresist pattern by means of an etching process having a high selective etching ratio to said first interlayer insulator film, and etching said first interlayer insulator film exposed in an opening thereby formed in said second interlayer insulator film.

By "high selective etching ratio" we mean that the etching process etches the second interlayer insulator film at a signficantly higher rate (preferably not less than 1.3 times higher) than the first interlayer insulator film. This enables the second interlayer insulator film to be removed to the bottom of the selected concave region without excessive etching of parts of the first interlayer insulator film which may be exposed during the etching process.

The above and other objects, features and advantages of the present invention will be apparent from the following description of preferred embodiments of the invention with reference to the accompanying drawings.

### **Brief Description of the Drawings**

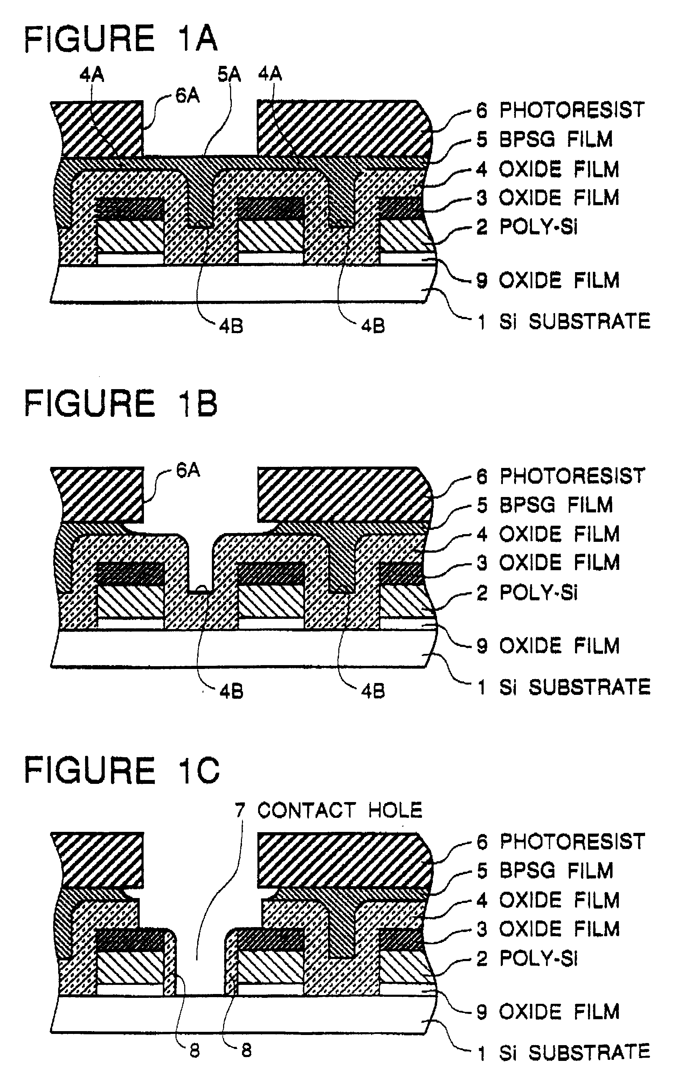

Figures 1A to 1C are diagrammatic partial sectional views of a semiconductor device for illustrating the steps of the method in accordance with a preferred embodiment of the present invention for manufacturing the semiconductor device.

## Description of the Preferred embodiments

Referring to Figure 1A, there is shown a condition in which first and second interlayer insulator films and a photoresist are formed in the named order on a principal surface of a silicon substrate 1 on which a plurality of gate electrodes and/or wirings are formed. Each of the gate electrodes and/or wirings includes a polysilicon 2 formed through a thin silicon oxide film 9 on the silicon substrate 1 and a silicon oxide film 3 formed on the polysilicon 2. In case of a gate electrode, the thin silicon oxide film 9 is a gate oxide film. Additionally, one or more doped regions are formed in a surface region of the substrate 1 under the polysilicon 2 and/or between a selected pair of adjacent polysilicons.

After the polysilicon 2 and the silicon oxide film 3 are formed, a silicon oxide film 4 is deposited by a low pressure CVD (chemical vapor deposition) so as to form the first interlayer insulator film. This silicon oxide film 4 preserves a step pattern or a convex/concave pattern formed by the stacked layers of the polysilicon 2 and the silicon oxide film 3 on the substrate 1. Namely, the silicon oxide film 4 has a convex 4A corresponding to each stacked layer and a concave 4B corresponding to an area between each pair of adjacent stacked layers.

Next, a BPSG (borophosphosilicate glass) film 5 is deposited by an atmospheric pressure CVD so as to form a second interlayer insulator film, and then, heat-treated at a temperature of 950°C in a nitrogen atmosphere so as to completely fill the concaves 4B of the underlying silicon oxide film 4. Therefore, the BPSG film 5 has an planarized upper surface 5A.

Thereafter, a photoresist 6 is coated on the BPSG film 5. The photoresist 6 is patterned to have an opening 6A which is positioned above a selected one of the concaves 4B of the silicon oxide film 4. This opening 6A has a size larger than that of a concave formed between a pair of adjacent stacked layers.

Thereafter, as shown in Figure 1B, a first etching is performed in a reaction chamber of a parallel flat plate electrode structure having a positive electrode applied with a high frequency electric power, and with a plasma of a mixed gas consisting of $CF_4$ and $O_2$, under a condition of a total amount of gas flow of 400 sccm, a partial pressure of $O_2$ of 10% and a pressure of 1 Torr.

In this etching process, the etching condition is set or adjusted to ensure that the etching rate of the BPSG film 5 (the second interlayer insulator layer) is not less than 1.3 times the etching rate of the silicon oxide film 4 (the first interlayer insulator layer). Thus, within the opening 6A of the photoresist 6, a bottom of the selected concave 4B of the silicon oxide film 4 is exposed as shown in Figure 1B.

Then, as shown in Figure 1C, a second etching is performed in the same reaction chamber as that used for the first etching, by applying a high frequency electric power to a negative electrode, and with a plasma of a mixed gas consisting of $CF_4$ and $H_2$, under a condition of a total amount of gas flow of 100 sccm, a partial pressure of $H_2$ of 10% and a pressure of 50 mTorr.

Thus, a contact hole 7 is formed in a self alignment with the concave formed in the step pattern on the substrate 1. Simultaneously, a portion 8 of the silicon oxide 4 film remains on a side wall of the stacked layers of the polysilicon 2 and the oxide film 3, so that an upper surface and opposite side surface the polysilicon 2 are completely covered by an insulator film of the silicon oxide film 4.

In the above mentioned embodiment, the first interlayer insulator film can be formed of a silicon nitride film or a silicon oxide/nitride film instead of the silicon oxide film 4. The second interlayer insulator layer can be formed of a PSG (phosphosilicate glass) film, an insulative organic film such as a polyimide film, or an insulative organic glass film, in place of the BPSG film 5. In these cases, a similar effect can be obtained.

In addition, for the etching of the first and second interlayer insulator films, there can be used a mixed gas plasma composed of a combination of fluorocarbon such as $C_2F_6$, $C_3F_8$, $CHF_3$, $C_2H_2F_4$, $C_3HF_7$, $C_3H_2F_6$, $C_3H_3F_5$, etc., and a carrier gas such as $O_2$, $N_2$, He, Ar, $H_2$, etc.

Furthermore, in the process of etching the first and second interlayer insulator films, a coaxial type or a down-flow type of plasma etching apparatus can be used instead of the parallel flat plate type. In addition, a reactive ion etching apparatus of the parallel flat plate type, the ECR discharge type or the magnetic field application type can be used independently for each of the first and second interlayer insulator films or continuously for both of the first and second interlayer insulator films.

As seen form the above, after removal of the photoresist 6, a planarized upper surface remains other than the contact hole. Namely, the concaves due to the stacked layers of the polysilicon 2 and the oxide film 3 on the substrate 1 is completely planarized by the second interlayer insulator 5. Accordingly, the upper layer wiring metallization is prevented from being broken at a convex of the step and also from being short-circuited by a residue of metallization in the concave of the step.

On the other hand, since the first interlayer insulator film is etched after the second interlayer insulator film was etched under an etching condition having a high selective etching ratio to the first interlayer insulator film, the contact hole can be formed without losing the self-alignment feature.

The invention has thus been shown and described with reference to the specific embodiments. However, it should be noted that the present invention is in no way limited to the details of the illustrated structures but changes and modifications may be made within the scope of the appended claims.

**Claims**

1. A method for manufacturing a semiconductor device, comprising the steps of depositing a first interlayer insulator film on a principal surface of a substrate on which a step pattern having a plurality of concave and convex regions is formed, so as to cover the plurality of concave and convex regions and to preserve said step pattern, depositing a second interlayer insulator film on a whole upper surface of said first interlayer insulator film so as to form a substantially planar surface over said step pattern, forming on said second interlayer insulator film a photoresist pattern having an opening at a position corresponding to a selected said concave region in said step pattern, etching said second interlayer insulator film exposed in said opening of said photoresist pattern by means of an etching process having a high selective etching ratio to said first interlayer insulator film, and etching said first interlayer insulator film exposed in an opening thereby formed in said second interlayer insulator film.

2. A method as claimed in Claim 1, wherein the selective etching ratio is not less than 1.3

3. A method claimed in Claim 1 or 2, wherein each of said convex regions on said substrate includes a polysilicon layer which does not exist in the said concave regions.

4. A method as claimed in Claim 3, wherein said first interlayer insulator film is formed of a material selected from the group consisting of silicon oxide, silicon nitride, and silicon oxide/nitride film, and said second interlayer insulator layer is formed of a material selected from the group consisting of PBSG, PSG, insulative organic resin, or insulative organic glass.

5. A method claimed in Claim 3 wherein each of said first and second interlayer insulator films is etched using a mixed gas plasma composed of fluorocarbon selected from the group consisting of $C_2F_6$, $C_2F_7$, $CHF_3$, $C_2H_2F$, $C_3HF_7$, $C_3H_2F_6$, and $C_3H_3F_5$, and a carrier gas selected from the group consisting of $O_2$, $N_2$, He, Ar, and $H_2$.

# FIGURE 1A

4A  6A  5A  4A

6 PHOTORESIST
5 BPSG FILM
4 OXIDE FILM
3 OXIDE FILM
2 POLY-Si
9 OXIDE FILM
1 Si SUBSTRATE

4B  4B

# FIGURE 1B

6A

6 PHOTORESIST
5 BPSG FILM
4 OXIDE FILM
3 OXIDE FILM
2 POLY-Si
9 OXIDE FILM
1 Si SUBSTRATE

4B  4B

# FIGURE 1C

7 CONTACT HOLE

6 PHOTORESIST
5 BPSG FILM
4 OXIDE FILM
3 OXIDE FILM
2 POLY-Si
9 OXIDE FILM
1 Si SUBSTRATE

8  8

**European Patent Office**

# EUROPEAN SEARCH REPORT

Application Number

EP    92 30 0574

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | GB-A-2 023 342 (RCA)<br>* page 4, line 18 - page 5, line 50; figures 8-12 * | 1,3-5 | H01L21/3105<br>H01L21/60<br>H01L21/90 |
| A | EP-A-0 280 276 (TOSHIBA)<br>* column 3, line 5 - column 4, line 13; figures 1A-1E * | 1 | |
| A | EP-A-0 376 479 (TOSHIBA)<br>* column 3, line 31 - line 49; figures 2A-2D * | 1,3,4 | |

| | |
|---|---|
| | **TECHNICAL FIELDS SEARCHED (Int. Cl.5 )** |
| | H01L |

The present search report has been drawn up for all claims

| Place of search | Date of completion of the search | Examiner |
|---|---|---|
| BERLIN | 09 APRIL 1992 | ROUSSEL A.T. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)